# EUROPÄISCHE PATENTSCHRIFT

(11) **EP 1 266 234 B1**
(45) Veröffentlichungstag und Bekanntmachung des Hinweises auf die Patenterteilung: **21.04.2004**
(21) Anmeldenummer: 00960608.8
(22) Anmeldetag: 05.09.2000
(51) Int. Cl.: G01R 31/28, G01R 1/073

(54) **VORRICHTUNG ZUM TESTEN VON LEITERPLATTEN**
TESTING DEVICE FOR PRINTED BOARDS
DISPOSITIF POUR LE TEST DE CARTES IMPRIMEES

(30) Priorität: 20.03.2000 DE 20005123 U
(43) Veröffentlichungstag der Anmeldung: 18.12.2002
(73) Patentinhaber: ATG TEST SYSTEMS GmbH & Co. KG, 97877 Wertheim (DE)
(72) Erfinder: PROKOPP, Manfred, 97877 Wertheim Reicholzheim (DE)
(74) Vertreter: Ganahl, Bernhard
(86) Internationale Anmeldenummer: PCT/EP2000/008669
(87) Internationale Veröffentlichungsnummer: WO 2001/071371

(56) Entgegenhaltungen:
- EP-A- 0 722 090
- WO-A-00/17662
- "OPEN-FRAME PRODUCT CRADLE FOR PROBING" IBM TECHNICAL DISCLOSURE BULLETIN,US,IBM CORP. NEW YORK, Bd. 38, Nr. 12, 1. Dezember 1995 (1995-12-01), Seiten 495-496, XP000588216 ISSN: 0018-8689

## Beschreibung

Die vorliegende Erfindung betrifft eine Vorrichtung und ein Verfahren zum Prüfen von Leiterplatten mit
einem Kontaktfeld,
Kontaktfingern, die in einer Ebene parallel zum Kontaktfeld verfahrbar angeordnet sind, wobei zwei Kontaktfinger ein Sondenpaar bilden, das Bestandteil eines Prüfstromkreises ist,
einer Steuereinrichtung zum Positionieren der Kontaktfinger auf Leiterplättentestpunkten einer zu testenden Leiterplatte, wobei während eines Prüfvorganges die gleichzeitig in die Prüfvorrichtung einbringbaren Leiterplatten geprüft werden, und zwei Sätzen von Kontaktfingern, wobei ein Satz zum Prüfen der Vorderseite und der andere Satz zum Testen der Rückseite einer der zu testenden Leiterplatte angeordnet sind.

Vorrichtungen zum Testen von Leiterplatten, insbesondere unbestückten Leiterplatten, können grundsätzlich in zwei Gruppen eingeteilt werden, nämlich den Fingertestern und den Paralleltestern.

Fingertester sind Vorrichtungen, bei welchen die einzelnen Leiterplattentestpunkte einer zu prüfenden Leiterplatte sequentiell abgetastet werden, indem eine an einem Schlitten angeordnete Prüfsonde entlang einer Traverse über der zu testenden Leiterplatte verfahren wird, wobei sie über jeweils einen abzutastenden Leiterplattentestpunkt positioniert werden kann, der dann mittels einer Sonde kontaktiert wird. Ein derartiger Fingertester weist zumindest zwei Kontaktfinger auf, so dass er eine Leiterbahn der zu testenden Leiterplatte an zwei Leiterplattentestpunkten kontaktieren kann und den dazwischenliegenden Abschnitt prüfen kann, ob darin eine Unterbrechung oder ein Kurzschluss vorliegt.

Ein solcher Fingertester ist beispielsweise in der EP 0 486 153 A1 beschrieben. Die Vorzüge der Fingertester liegen darin, dass mit ihnen unterschiedlichste Arten von Leiterplatten getestet werden können, ohne dass hierbei irgendwelche mechanischen Umbauten notwendig sind. Zudem können mit Fingertestern alle beliebigen Leiterplattentypen getestet werden. Die Erfindung betrifft einen derartigen Fingertester.

Paralleltester sind Prüfvorrichtungen, die mittels einer Kontaktanordnung, die in der Regel durch einen Adapter dargestellt wird, alle oder zumindest die meisten Kontaktstellen einer zu prüfenden Leiterplatte gleichzeitig kontaktieren, Mit derartigen Paralleltestern kann eine große Anzahl von Leiterplattentestpunkten schnell und sicher abgetastet werden.

Die Vorteile eines Paralleltesters gegenüber einem Fingertester liegen darin, dass mit einem Paralleltester wesentlich schneller eine Leiterplatte getestet werden kann, da alle Messvorgänge im wesentlichen gleichzeitig ausgeführt werden. Jedoch muss bei einem Wechsel des Leiterplattentyps der zu testenden Leiterplatten eine neue Kontaktanordnung vorgesehen werden, was in der Regel durch die Herstellung eines neuen Adapters erfolgt.

Paratleltester werden deshalb bevorzugt bei der Produktion mit hohen Stückzahlen eingesetzt, da mit ihnen ein hoher Durchsatz erzielt werden kann.

Aus obigen folgt unmittelbar, dass eines der wesentlichen Kriterien zu erfolgreichen Vermarktung eines Fingertesters desse Prüfgeschwindigkeit ist, mit welcher eine zu testende Leiterplatte getestet werden kann, da Fingertester im Prinzip bedingt langsamer als Paratleltester sind.

Mit dem aus der EP 0 468 153 A1 bekannten Fingertester können eine oder mehrere zu prüfende Leiterplatten gleichzeitig sowohl an der Vorder- als auch an der Rückseite getestet werden. Hierzu sind zwei Sätze von Kontaktfingern vorgesehen, die jeweils auf einer der beiden Seiten eines Kontaktfeldes angeordnet sind. Das Kontaktfeld ist in der Regel horizontal ausgerichtet, so dass der eine Satz von Kontaktfingern oberhalb des Kontaktfeldes und der andere Satz vom Kontaktfingern unterhalb des Kontaktfeldes angeordnet ist. Die zu prüfenden Leiterplatten werden in der Prüfvorrichtung, dem Fingertester, mittels zweier U-Schienen gehalten, in welchen die Leiterplatten mit ihren Rändern lagern.

Femer ist es bekannt, plattenförmige Produkthalter für spezielle Leiterplatten zu verwenden, die nicht mittels zweier gegenüberliegender Schienen gehalten werden können. Derartige spezielle Leiterplatten weisen z.B. eine nicht in die Schienen einschiebbare Form auf oder sind so biegsam ausgebildet, dass sie an ihrem vollständigen Umfang unterstützt werden müssen.

Ferner ist es bekannt, bei Fingertestem vorab beispielsweise mittels einer Kamera, Versätze der Leiterplattentestpunkte einer zu testenden Leiterplatte gegenüber der Idealposition zu messen und diese Versätze bei der Positionierung der Kontaktfinger zu berücksichtigen. Gleichermaßen werden auch Verzüge von Leiterplatten bestimmt und berücksichtigt. Die zu testenden Leiterplatten werden in den Schienen gegen einen Anschlag eingeschoben. Die einzelnen Leiterplattentestpunkte sind dann in einem durch den Anschlag festgelegten Koordinatensystems ausgerichtet.

Von Paralleltestern ist es bekannt, falls eine Abweichung der Ist-Lage von der Soll-Lage der Leiterplattentestpunkte festgestellt wird, diese durch Verschieben der Leiterplatten bzw. des Adapters auszugleichen. Derartige Verfahren und Vorrichtungen sind beispielsweise in der DE 43 02 509 A1, JP 4038480 und der EP 0 874 243 A2 offenbart. Es sind auch diverse Vorrichtungen bekannt, mit welchen die Leiterplatten bezüglich der Kontaktanordnung ausgerichtet werden können. Hierzu wird beispielhaft auf die DE 44 17 811 A1, DE 43 42 654 A1, US 4,820,975, EP 0 859 239 A2 und die EP 0 831 332 A 1 verwiesen. Neben den optischen Verfahren zum Bestimmen der Abweichung sind auch elektrische Messverfahren zum Bestimmen dieser Abweichungen bekannt (z.B. EP 0 874 243 A2).

Die EP 0 722 090 A2 beschreibt eine Haltevorrichtung für flächenförmige Prüflinge, die dem Prüfling auf seinen beiden, einander gegenüberliegenden Oberflächen mit Haltemitteln abstützt. Mindestens eines der Haltemittel ist aus elektrisch nicht leitender, von Kontaktfingern durchstoßbarer Folie ausgebildet.

Die WO 00/17662 betrifft eine Vorrichtung zum Testen von mit elektrischen Bauteilen bestückten Modulen. Sie weist einen als Tray bezeichneten Probenhalter auf, in dem mehrere mit elektrischen Bauteilen bestückte Module eingesetzt werden können. Diese Module besitzen an der Unterseite im Bereich eines Randes elektrische Kontaktelemente. Im Bereich dieses Randes werden die Module mit einem von unten zuführbaren Trägerelement kontaktiert, das mit Kontaktumlenkungselementen versehen ist, mit welchen die elektrischen Kontakte der Module nach oben umgelenkt werden können. Von oben wird ein Testkopf abgesenkt, der sowohl diese Kontaktumfenkungselemente als auch die Module zum Testen desselben kontaktiert.

Aus "OPEN-FRAMS PRODUGT CRADLE FOR PROBING" IBM TECHNICAL DISC-LOSURE BULLETIN, US, IBM CORP. NEW YORK, Bd. 38, Nr. 12, 1. Dezember 1995, Seiten 495-496 geht ein Produkthalter hervor, in dem Multi-Chip-Module oder Leiterplatten eingesetzt werden können. Für jedes Modul bzw. für jede Leiterplatte ist eine Öffnung vorgesehen, wobei angrenzend zu den Öffnungen Fixiermittel zum Fixieren der Module bzw. Leiterplatten auf dem Produkthalter angeordnet sind.

Der Erfindung liegt die Aufgabe zugrunde eine eingangs genannte Vorrichtung zum Prüfen von Leiterplatten derart weiterzubilden, dass auf einfache Art und Weise der Durchsatz von Leiterplatten gegenüber bekannten Vorrichtungen erhöht wird. Ferner soll mit der Erfindung ein entsprechendes Verfahren zum Erhöhen des Durchsatzes von Leiterplatten beim Prüfen mit einem Fingertester geschaffen werden.

Die Aufgabe wird durch eine Vorrichtung mit den Merkmalen des Anspruchs 1 und durch ein Verfahren mit den Merkmalen des Anspruchs 11 gelöst.

Die erfindungsgemäße Vorrichtung zum Prüfen von Leiterplatten zeichnet sich dadurch aus,
dass eine Halteeinrichtung zwischen den beiden Sätzen von Kontaktfingern angeordnet ist, und die Halteeinrichtung Aufnahmebereiche zum Aufnehmen von zumindest zwei zu testenden Leiterplatten aufweist, wobei zumindest eine der zu testenden Leiterplatten mit ihrer Vorderseite und die andere zu testende Leiterplatte mit ihrer Rückseite zu einem der beiden Sätze von Kontaktfingern weisend in die Halteeinrichtung einsetzbar sind, und dass die Steuereinrichtung derart ausgebildet ist, dass mit beiden Sätzen von Kontaktfingern die Leiterplattentestpunkte sowohl der Vorderals auch der Rückseiten der zu testenden Leiterplatten während eines Prüfvorganges kontaktierbar sind.

Die erfindungsgemäße Vorrichtung zum Prüfen von Leiterplatten ist derart ausgebildet, dass die Leiterplatten "revers" anordbar sind, das heißt dass eine bestimmte Anzahl von Leiterplatten mit ihrer Vorderseite z.B. nach oben weisend und die anderen Leiterplatten mit ihrer Rückseite nach oben weisend angeordnet sind. Hierdurch wird eine, den meisten gängigen Leiterplatten eigene Eigenschaft, ausgenützt, nämlich dass die Leiterplatten auf einer Seite wesentlich mehr Leiterplattentestpunkte als auf der anderen Seite aufweisen. Ein Verhältnis der Anzahl der Leiterplattentestpunkte von der Vorder- gegenüber der Rückseite von 10:1 ist nicht ungewöhnlich. Eine zu testende Leiterplatte weist z.B. auf der Vorderseite 10.000 Leiterplattentestpunkte und auf der Rückseite lediglich 1.000 Leiterplattentestpunkte auf. Da bei der erfindungsgemäßen Vorrichtung die zu testenden Leiterplatten sowohl mit der Vorder- als auch mit der Rückseite zu einem Satz von Kontaktfingem weisend angeordnet werden, und die Steuereinrichtung derart ausgebildet ist, dass sowohl von einem solchen Satz Leiterplattentestpunkte die Vorder- als auch die Rückseiten der zu testenden Leiterplatten kontaktierbar sind, werden von beiden Sätzen von Kontaktfingern jeweils etwa die gleiche Anzahl Leiterplattentestpunkte getestet. Ist eine gerade Anzahl von Leiterplatten in die Prüfvorrichtung einbringbar, so werden vorzugsweise die Hälfte der Leiterplatten mit der Vorderseite und die andere Hälfte der Leiterplatten mit der Rückseite zu jeweils einem der beiden Sätze weisend in der Prüfvorrichtung angeordnet. Hierdurch werden von beiden Sätzen von Leiterplatten die gleiche Anzahl Vorderseiten als auch Rückseiten des zu testenden Leiterplattentyps getestet, wodurch beide Sätze von Kontaktfingern die gleiche Anzahl von Leiterplattentestpunkte testen. Hierdurch werden beide Sätze von Kontaktfingern exakt gleichmäßig ausgelastet.

Bei herkömmlichen Prüfvorrichtungen ist lediglich eine der beiden Sätze von Kontaktfingern voll ausgelastet, nämlich derjenige Satz von Kontaktfingern, der die Seite der zu testenden Leiterplatten zu kontaktieren hat, die die meisten Leiterplattentestpunkte aufweist. Der andere Satz von Kontaktfingern muss bei herkömmlichen Prüfvorrichtungen lediglich eine wesentlich geringere Anzahl von Leiterplattentestpunkten kontaktieren, weshalb während eines Prüfvorgangs dieser Satz von Leiterplattentestpunkten oftmals untätig abwarten musste, bis der andere Satz von Leiterplattentestpunkten seine Messungen abgeschlossen hat. Diese Totzeit wird mit der erfindungsgemäßen Prüfvorrichtung elimeniert oder zumindest auf ein Minimum beschränkt.

Die Erfindung wird nachfolgend anhand der beigefügten Zeichnungen näher erläutert, die ein Ausführungsbeispiel der Erfindung zeigen. Die Zeichnungen zeigen schematisch:
- Fig. 1: eine erfindungsgemäße Vorrichtung zum Prüfen von Leiterplatten in der Draufsicht,
- Fig. 2: die Vorrichtung aus Fig. 1 in der Seitenansicht,
- Fig. 3: eine erfindungsgemäße Halteplatte (ohne Leiterplatten) in der Draufsicht,
- Fig. 4a: die Halteplatte (mit Leiterplatten) aus Fig. 3 in einer Schnittdarstellung entlang der Linie A - A mit Blick in Pfeilrichtung, und
- Fig. 4b: eine weitere Ausführungsform der Halteplatte (mit Leiterplatten) in einer Schnittdarstellung, und
- Fig. 5: ein weiteres Ausführungsbeispiel einer erfindungsgemäßen Vorrichtung zum Prüfen von Leiterplatten mit feststehenden Traversen und Schwenkarmen, an welchen die Kontaktfinger angeordnet sind.

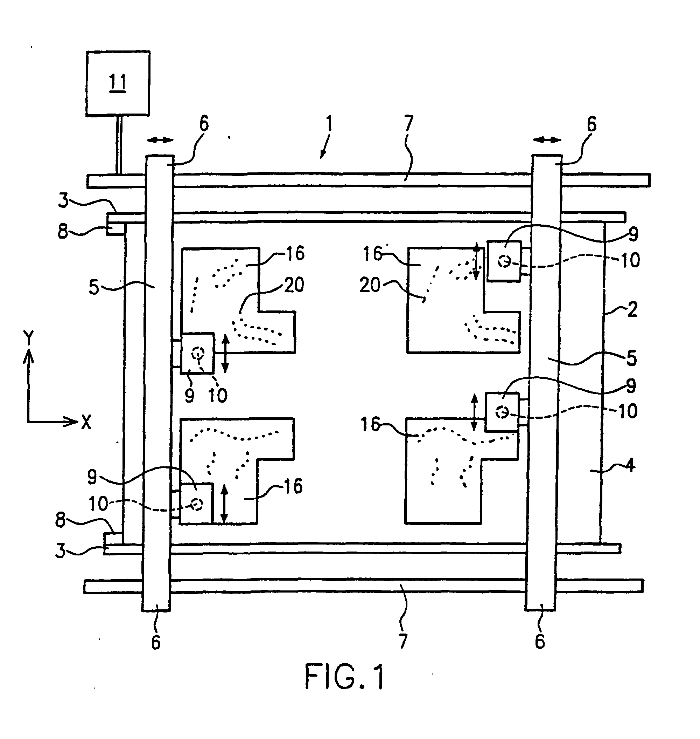

Fig. 1 zeigt schematisch in einer Draufsicht eine erfindungsgemäße Prüfvorrichtung, wobei nur für die Erfindung wesentliche Komponenten dargestellt sind. Insofern sind ebenfalls für die Funktion dieser Vorrichtung erforderliche, jedoch für die Erfindung unwesentliche Teile weggelassen.

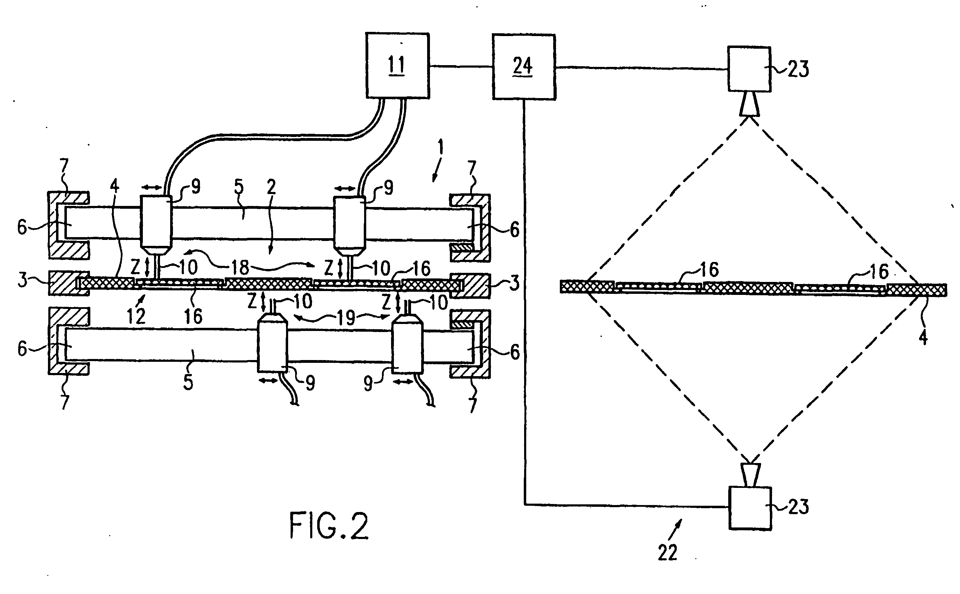

Die Prüfvorrichtung 1 weist ein Prüffeld 2 auf, das seitlich mittels zweier U-Schienen 3 zur Aufnahme einer erfindungsgemäßen Halteplatte 4 begrenzt ist (Fig. 2).

Das Prüffeld 2 wird von zwei Traversen 5 überspannt, die mit ihren Endbereichen 6 verfahrbar auf Führungsschienen 7 angeordnet sind.

Jeweils eine der U-Schienen 3 ist parallel und benachbart zu einer der Führungsschienen 7 angeordnet. Die U-Schienen 3 weisen mit ihren Öffnungen zum Prüffeld 2 und sind jewils an einem Ende mit einem Anschlag 8 versehen, so dass die Halteplatte 4 in die U-Schienen 3 eingeschoben werden kann, bis sie an den Anschlägen 8 anliegt. An den Traversen 5 sind Positionierglieder 9 verfahrbar angeordnet. Jedes Positionierglied 9 weist einen Kontaktfinger 10 auf, der vertikal verschieblich (Z-Richtung) an dem jeweiligen Positionierglied 9 angeordnet ist.

Da die Traversen 5 entlang den Führungsschienen 7 und die Positionierglieder 9 entlang den Traversen 5 verfahrbar sind, können die Positionierglieder 9 in der Ebene des Prüffeldes 2 an eine beliebige Stelle in X-Richtung und Y-Richtung verfahren werden. Die Bewegung der Positionierglieder wird durch eine Steuereinrichtung 11 gesteuert.

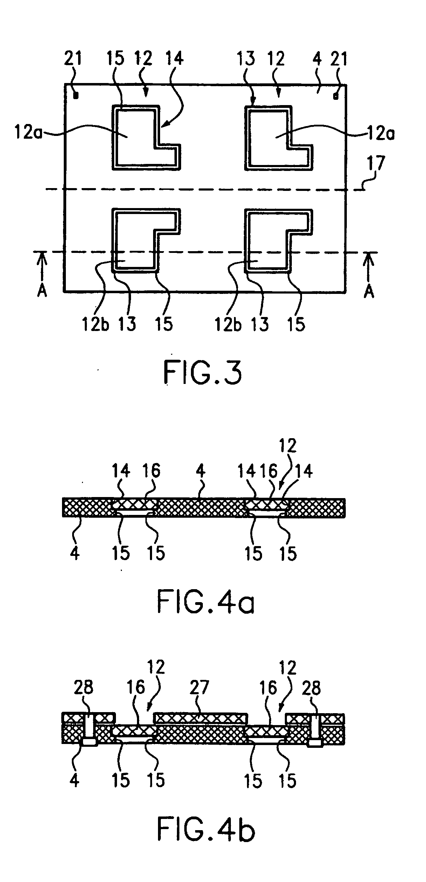

In die Halteplatte 4 sind Ausnehmungen 12 eingebracht (Fig. 3, 4a), die der Form der zu testenden Leiterplatten entsprechen. Die Ausnehmungen 12 weisen jeweils einen Begrenzungsrand 13 auf, der im dargestellten Ausführungsbeispiel durch eine vertikal verlaufende Begrenzungswandung 14 und einen am Begrenzungsrand 13 umlaufenden Vorsprung 15 dargestellt ist, wobei der Vorsprung 15 unterhalb der Begrenzungswandung 14 einstückig an der Halteplatte 4 derart ausgebildet ist, dass er mit deren unteren Seitenfläche bündig abschließt.

Die Begrenzungswandung 14 einer Ausnehmung 12 ist exakt der Form einer zu testenden Leiterplatte 16 angepasst, so dass diese formschlüssig in der Ausnehmung 12 aufnehmbar ist und durch den Vorsprung 15, der als Halteelement dient, gegen ein Herausfallen aus der Ausnehmung 12 gesichert ist.

Die in Fig. 4b gezeigte Halteplatte 4 muß nicht mit formschlüssigen Ausnehmungen 12 ausgebildet sein, da die zu testenden Leiterplatten 16 zwischen den Vorsprüngen 15 der Halteplatte 4 und einer auf der Halteplatte 4 angeordneten Gegenplatte 27 fixiert sind. Die Gegenplatte ist mittels einer Schraubverbindung 28 an der Halteplatte 4 derart befestigt, dass die zu testenden Leiterplatten zwischen der Gegenplatte 27 und der Halteplatte 4 eingeklemmt und dadurch in ihrer Lage fixiert sind.

Zum Fixieren der zu testenden Leiterplatten 16 können anstelle einer Gegenplatte auch Klebestreifen verwendet werden.

An der Halteplatte 4 sind zwei Arten von Ausnehmungen 12a, 12b vorgesehen, die in der Draufsicht eine zueinander spiegelsymmetrische Form besitzen. Bei dem in Fig. 3 dargestellten Ausführungsbeispiel sind die Ausnehmungen 12a, 12b, jeweils um eine Symmetrieachse 17 spiegelsymmetrisch angeordnet. Die Ausnehmungen 12 können jedoch auch in einer beliebigen Richtung versetzt bzw. gedreht angeordnet sein, so dass zwischen einem Paar spiegelsymmetrisch geformter Ausnehmungen keine Symmetrieachse festlegbar ist. Für die Erfindung ist wesentlich, dass die zu testenden Leiterplatten 16 derart in die Halteplatte 4 eingelegt werden können, dass ein Teil der Leiterplatten 16 mit Ihren Vorderseiten zu einer Seite der Halteplatte 4 und ein anderer Teil der Leiterplatten mit ihren Vorderseiten zu der anderen Seite der Halteplatte 4 weisend in die Halteplatte 4 einsetzbar sind. Beim dargestellten Ausführungsbeispiel werden in die Ausnehmung 12a Leiterplatten mit Ihrer Rückseite auf den Vorsprüngen 15 aufliegend angeordnet, wohingegen sie in den Ausnehmungen 12b mit ihren Vorderseiten auf den Vorsprüngen 15 aufliegend eingesetzt werden.

Mehrere auf die Halteplatte 4 eingesetzte zu testende Leiterplatten 16 - im dargestellten Ausführungsbeispiel sind es vier zu testende Leiterplatten 16 - werden als Einheit in die U-Schienen 3 der Prüfvorrichtung bis zum Anschlag 8 eingeschoben.

Da ein Teil der zu testenden Leiterplatten 16 mit ihren Vorderseiten zu den oberen Kontaktfingern 10 - erster Satz 18 Kontaktfinger - und der andere Teil der Leiterplatten zu den unteren Kontaktfingern 10 - zweiter Satz 19 Kontaktfinger- weisen, sind beiden Sätzen von Kontaktfingern 18, 19 jeweils Vorder- und Rückseiten der zu testenden Leiterplatten 16 zugewandt (Fig. 2)

Die Steuereinrichtung 11 ist derart ausgebildet, dass mit den Kontaktfingern 10 beider Sätze von Kontaktfingern 18, 19 Leiterplattentestpunkte 20 der Vorder- und Rückseiten der zu testenden Leiterplatten 16 kontaktierbar sind.

Hierzu werden die Prüfprogramme für eine zu testende Leiterplatte, in welchen die Koordinaten der Leiterplattentestpunkte und die Reihenfolge, mit welcher die Leiterplattentestpunkte 20 kontaktiert werden, gespeichert sind, für die revers eingesetzten Leiterplatten 16 zwischen den beiden Sätzen von Kontaktfingern 18, 19 vertauscht. Die erfindungsgemäße Steuereinrichtung weist somit ein "normales" Prüfprogramm für die Leiterplatten, deren Vorderseite nach oben gerichtet sind und ein "vertauschtes" Prüfprogramm für die revers eingesetzten Leiterplatten, deren Rückseite nach oben gerichtet sind, auf. Diese Prüfprogramme werden entsprechend der jeweiligen Anzahl von in der Halteplatte 4 eingesetzten Leiterplatten vervielfacht und an die entsprechenden Positionen der Leiterplatten in der Halteplatte 4 bzw. in der Prüfvorrichtung 1 skaliert. Üblicherweise sind auf den Vorder- und Rückseiten der zu testenden Leiterplatten die Leiterplattentestpunkte mit sich deutlich unterscheidender Anzahl angeordnet. Das Verhältnis zwischen den Leiterplattentestpunkten auf der Vorderseite und den Leiterplattentestpunkten auf der Rückseite liegt oftmals im Bereich von 3:1 bis 20:1. Es gibt auch Leiterplatten, die auf der Rückseite keine Leiterplattentestpunkte besitzen. Da mit der erfindungsgemäßen Vorrichtung beide Sätze 18, 19 von Kontaktfingern sowohl Vorder- als auch Rückseiten von den zu testenden Leiterplatten kontaktieren, werden von beiden Sätzen 18, 19 Kontaktfingem eine mittlere Anzahl Leiterplattentestpunkte gegenüber dem Fall, dass ein Satz von Kontaktfingern lediglich nur Vorderseiten und der andere Satz von Kontaktfingern lediglich nur Rückseiten der zu testenden Leiterplatte kontaktiert. Im Idealfall, bei dem die gleiche Anzahl von Leiterplatten mit ihren Vorderseiten zu dem einen Satz von Kontaktfingern weisend und zu dem anderen Satz von Kontaktfingern weisend angeordnet sind, sind von jedem Satz Kontaktfingern jeweils exakt gleich viel Leiterplattentestpunkte zu kontaktieren. Bei einer solchen Anordnung sind die beiden Sätze von Kontaktfingern exakt gleichmäßig während eines Prüfvorganges ausgelasted, währenddessen alle gleichzeitig in die Prüfvorrichtung einbringbaren Leiterplatten getestet werden. Dies bedeutet einen erheblichen Zeitvorteil gegenüber bekannten Prüfvorrichtungen, bei welchen lediglich mit einem Satz von Kontaktfingern die Vorderseiten einer zu testenden Leiterplatte und mit dem anderen Satz von Kontaktfingern die Rückseiten der zu testenden Leiterplatten getestet werden, da bei diesen bekannten Vorrichtungen der Satz von Kontaktfingern, der die geringere Anzahl von Leiterplattentestpunkten zu kontaktieren hat, nie vollständig ausgelastet ist und hier erhebliche Totzeiten bestehen, in welchen die Kontaktfinger des einen Satzes warten, bis die Kontaktfinger des anderen Satzes die entsprechenden Testmessungen durchführen.

Vorzugsweise sind an der Halteplatte 4 zumindest zwei elektrisch leitende Kontaktpunkte 21 angebracht, die von den Kontaktfingern 10 erfasst werden können (Fig. 3). Hierdurch kann die Position der Halteplatte 4 in der Prüfvorrichtung 1 eindeutig bestimmt werden. Ist die Position der Halteplatte 4 einmal ermittelt worden, so sind die Positionen der zu testenden Leiterplatten 16 bezüglich der Prüfvorrichtung 1 auch eindeutig bestimmt, da diese formschlüssig in der Halteplatte 4 eingesetzt sind. Somit können die Prüfprogramme für die einzelnen zu testenden Leiterplatten entsprechend in dem X-, Y-Koordinatensystem skaliert werden.

Bei einer bevorzugten Ausführungsform der erfindungsgemäßen Prüfvorrichtung (Fig. 2) ist eine Messstation zum Messen von Versätzen der Leiterplattentestpunkte einer jeden einzelnen Leiterplatte gegenüber deren Idealposition und zum Messen von Verzügen der Leiterplatten vorgesehen. Die Messstation weist zwei Kameras 23 auf, mit welchen jeweils eine Seite der Halteplatte 4 vollständig abgetastet werden kann. Die Kameras sind mit einer Auswerteeinrichtung 24 elektrisch verbunden, die die von den Kameras 23 erfassten Bildsignale digital zum Bestimmen der Versätze und Verzüge auswertet. Derartige Auswerteverfahren sind an sich bekannt, weshalb sie nicht im Einzelnen erläutert werden müssen. Diese Verfahren werden insbesondere bei Leiterplatten mit sehr hohen Leiterplattentestpunktdichte und sehr kleinen Leiterplattentestpunkten angewendet, da bei derartigen zu testenden Leiterplatten die herstellungsbedingten Versätze und Verzüge der Leiterplatten in der Größenordnung der Leiterplattentestpunkte liegen, wodurch bei einer Fehlausrichtung aufgrund von Versätzen und Verzügen Fehlkontaktierungen verursacht werden können. Mit den Kameras 23 und der Auswerteeinrichtung 24 werden diese Abweichungen der Leiterplattentestpunkte von ihrer Idealposition erfasst. Die so ermittelten "Abweichungsdaten" werden von der Auswerteeintrichtung 24 an die Steuereinrichtung 11 weitergegeben und beim Verfahren der Kontaktfinger 10 in einem Prüfvorgang entsprechend berücksichtigt, so dass die einzelnen Leiterplattentestpunkte jeweils korrekt kontaktiert werden.

Die Abweichungsdaten der Leiterplattentestpunkte der einzelnen auf die Halteplatte 4 eingesetzten Leiterplatten 16 werden bezüglich eines durch die Halteplatte 4 festgelegten Koordinatensystems (X-, Y-Richtung) bestimmt. Dieses Koordinatensystem ist beispielsweise durch die auf der Halteplatte 4 aufgebrachten Kontaktpunkte 21 eindeutig festgelegt.

Bei einer weiteren bevorzugten Weiterbildung der erfindungsgemäßen Prüfvorrichtung werden die Halteplatten 4 automatisch, beispielsweise mittels Förderbänder von der Messstation 22 in das Prüffeld 2 transportiert. Bei einer solchen automatisierten Prüfvorrichtung werden in das am Prüffeld 2 ausgeführten Prüfvorganges eine weitere Halteplatte 4, in die weitere zu testende Leiterplatten 16 eingesetzt sind, in der Messstation 22 vermessen. Durch das Vorsehen der Halteplatte 4 ist es somit möglich, die Versätze und Verzüge unabhängig vom Prüffeld 2 vorab zu vermessen. Bei bekannten Prüfvorrichtungen werden die Versätze und Verzüge nach dem Einsetzen der Leiterplatten in das Prüffeld gemessen. Während dieser Messvorgänge zum Bestimmen der Versätze und Verzüge konnte der eigentliche Prüfvorgang nicht durchgeführt werden, weshalb diese Messvorgänge so schnell wie möglich ausgeführt werden, um nicht die zur Verfügung stehende Prüfzeit zu sehr zu begrenzen. Bei der erfindungsgemäßen Vorrichtung mit einer separaten Messstation steht im Vergleich zu den bekannten Vorrichtungen wesentlich mehr Zeit zum Vermessen der Verzüge und Versätze zur Verfügung, weshalb die einzelnen Leiterplattentestpunkte wesentlich genauer vermessen werden können. Hierdurch wird insbesondere bei Leiterplatten mit hoher Leiterplattentestpunktdichte und sehr kleinen Leiterplattentestpunkten der Durchsatz der zu testenden Leiterplatten und die Qualität des Prüfvorganges durch die genaue Erfassung der Leiterplattentestpunkte erheblich gesteigert.

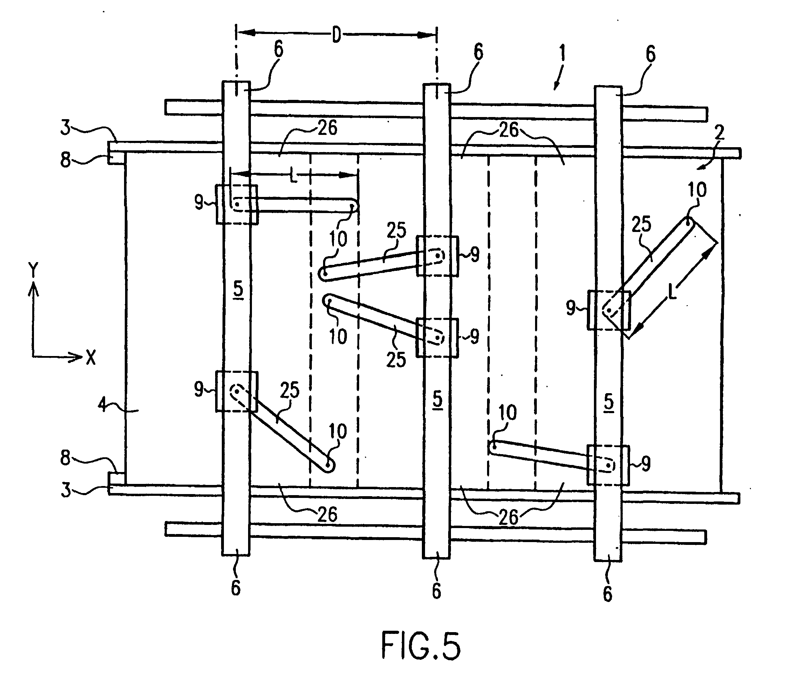

Fig. 5 zeigt ein weiteres Ausführungsbeispiel einer erfindungsgemäßen Prüfvorrichtung. Diese Prüfvorrichtung weist einen einfachen mechanischen Aufbau mit feststehenden Traversen 5 auf, an welchen Positionierglieder 9 verfahrbar angeordnet sind. Die Positionierglieder 9 sind mit Schwenkarmen 25 versehen, die in einer zum Prüffeld 2 parallelen Ebene schwenkbar an den Positioniergliedern 9 gelagert sind. An den von den Positioniergliedern 9 entfernten Enden der Schwenkarme 25 sind die Kontaktfinger 10 zum Kontaktieren der Leiterplattentestpunkte angeordnet. Der Abstand D zwischen zwei benachbarten Traversen 5 ist kleiner als die doppelte Länge L der Schwenkarme 25. Mit den einer Traverse 5 zugeordneten Kontaktfingern 10 kann eine Prüfzone 26 des Prüffeldes 2 abgetastet werden, dessen Ränder um L von der Traverse 5 beabstandet sind. Diese Prüfzonen 26 überlappen sich an ihren Randbereichen. In diesen überlappenden Bereichen können somit die Kontaktfinger 10 zwei unterschiedlicher Traversen 5 das Prüffeld abtasten, wodurch hier eine erhöhte Prüfgeschwindigkeit möglich ist. Die erfindungsgemäße Halteplatte 4 ist deshalb so ausgebildet, dass die Ausnehmungen 12 und damit die zu testenden Leiterplatten 16 in diesen überlappenden Bereichen der Prüfzonen 26 angeordnet sind, wodurch die Testgeschwindigkeit der Prüfvorrichtung weiter gesteigert wird.

Die Anordnung der Ausnehmungen 12 kann femer mittels eines Computerprogramms dahingehend optimiert werden, daß von den einzelnen Traversen etwa gleichviel Leiterplattentestpunkte zu kontaktieren sind. Ein derartiges Computerprogramm führt somit ein automatisches Verfahren zum Bestimmen der idealen Anordnung der zu testenden Leiterplatten auf dem Prüffeld 2 der Prüfvorrichtung 1 aus. Die Anordnung der zu testenden Leiterplatten wird somit nicht nur bezüglich der Sätze von Kontaktfingern sondern auch bezüglich der einzelnen Traversen optimiert.

Die Positionen der Ausnehmung 12 können bei anderen Arten von Prüfvorrichtungen entsprechend den Vorgaben dieser weiteren Prüfvorrichtungen optimiert festgelegt werden.

Die mit der Erfindung erzielten Vorteile können folgendermaßen kurz zusammengefasst werden:
- Es wird eine wesentlich bessere Auslastung der beiden Sätze von Kontaktfingern erzielt, da sie etwa die gleiche Anzahl von Leiterplattentestpunkten während eines Prüfvorganges kontaktieren.
- Mit der optionalen Messstation können Verzüge und Versätze vorab sehr genau ermittelt werden und bezüglich eines durch die Halteeinrichtung (Halteplatte 4) vorgegebenen Koordinatensystems festgelegt werden.
- Bei der Verwendung der Halteplatte 4 mit einem umlaufenden Vorsprung 15 und einer Begrenzungswandung 14, die eine formschlüssige Aufnahme für die zu testenden Leierplatten bildet, wird eine hohe Positioniergenauigkeit und Festigkeit erzielt, wobei Leiterplatten mit beliebigen Formen eingesetzt werden können.
- Durch die Verwendung einer Halteplatte, die mehrere zu testende Leiterplatten aufnehmen kann, reduziert sich die Belade- und Rüstzeit für die Prüfvorrichtung.
- Durch das gleichzeitige Handhaben und Testen mehrerer zu testenden Leiterplatten ergibt sich ein Automatisierungseffekt.

Die Erfindung ist oben anhand von Ausführungsbeispielen näher erläutert worden. Sie ist jedoch nicht auf die konkrete Ausführungsform der Ausführungsbeispiele beschränkt. Z.B. ist es im Rahmen der Erfindung auch möglich, an der Halteplatte 4 an Stelle eines um den Begrenzungsrand 13 der Ausnehmung 12 umlaufenden Vorsprung 15 mehrere abschnittsweise angeordnete Vorsprünge vorzusehen. An Stelle einer Halteplatte kann auch eine beliebige andere Halteeinrichtung vorgesehen werden, mit welcher zumindest zwei Leiterplatten ortsfest gehalten werden können, wobei eine der Leiterplatten mit ihrer Vorderseite nach oben und die andere Leiterplatte mit ihrer Rückseite nach oben anordbar ist.

### Bezugszeichenliste

- 1: Prüfvorrichtung
- 2: Prüffeld
- 3: U-Schiene
- 4: Halteplatte
- 5: Traverse
- 6: Endbereich
- 7: Führungsschiene
- 8: Anschlag
- 9: Positionierglied
- 10: Kontaktfinger
- 11: Steuereinrichtung
- 12: Ausnehmung
- 13: Begrenzungsrand
- 14: Begrenzungswandung
- 15: Vorsprung
- 16: zu testende Leiterplatte
- 17: Symmetrieachse
- 18: erster Satz Kontaktfinger
- 19: zweiter Satz Kontaktfinger
- 20: Leiterplattentestpunkt
- 21: Kontaktpunkt
- 22: Messstation
- 23: Kamera
- 24: Auswerteeinrichtung
- 25: Schwenkarm
- 26: Prüfzone
- 27: Gegenplatte

## Patentansprüche

1. Vorrichtung zum Prüfen von Leiterplatten mit
einem Prüffeld (2),
Kontaktfingern (10), die in einer Ebene parallel zum Prüffeld verfahrbar angeordnet sind, wobei zwei Kontaktfinger (10) ein Sondenpaar bilden, das Bestandteil eines Prüfstromkreises ist,
einer Steuereinrichtung (11) zum Positionieren der Kontaktfinger (10) auf Leiterplattentestpunkten (20) einer zu testenden Leiterplatte (16), wobei während eines Prüfvorganges die gleichzeitig in die Prüfvorrichtung (1) einbringbaren Leiterplatten (16) geprüft werden,
zwei Sätzen (18,19) von Kontaktfingern (10), wobei ein Satz (18) zum Prüfen der Vorderseite und der andere Satz zum Testen der Rückseite einer der zu testenden Leiterplatte (10) angeordnet sind, und
einer Halteeinrichtung (4) zwischen den beiden Sätzen (18,19) von Kontaktfingern (10) zum Halten einer zu testenden Leiterplatte (16),
**dadurch gekennzeichnet,**
**dass** die Halteeinrichtung (4) Aulnahmebereiche zum Aufnehmen von zumindest zwei zu testenden Leiterplatten (16) aufweist, wobei zumindest eine der zu testenden Leiterplatten (16) mit ihrer Vorderseite und die andere zu testende Leiterplatte (16) mit ihrer Rückseite zu einem der beiden Sätze (18,19) von Kontaktfingern (10) weisend in die Halteeinrichtung (4) einsetzbar sind, und
**dass** die Steuereinrichtung (11) derart ausgebildet ist, dass mit beiden Sätzen (18, 19) von Kontaktfingern (10) die Leiterplattentestpunkte (20) sowohl der Vorder- als auch der Rückseiten der zu testenden Leiterplatten (16) während eines Prüfvorganges kontaktierbar sind.

2. Vorrichtung nach Anspruch 1,
**dadurch gekennzeichnet,**
**dass** in die Halteeinrichtung (4) etwa die Hälfte der zu testenden Leiterplatten (16) mit ihrer Vorderseite zu einem der Sätze (18) Kontaktfinger (10) und die andere Hälfte der zu testenden Leiterplatten (16) mit ihrer Rückseite zu diesem Satz (18) Kontaktfinger (10) weisend einsetzbar sind.

3. Vorrichtung nach Anspruch 1 oder 2,
**dadurch gekennzeichnet,**
**dass** die Halteeinrichtung aus einer Halteplatte (4) ausgebildet ist, in welche Ausnehmungen (12) eingebracht sind, die etwa die Form der zu prüfenden Leiterplatten (16) aufweisen und die mit Halteelementen (15) zum Halten der zu prüfenden Leiterplatten (16) versehen sind.

4. Vorrichtung nach Anspruch 3,
**dadurch gekennzeichnet,**
**dass** die Halteelemente als vom Begrenzungsrand (13) der Ausnehmungen (12) vorstehende Vorsprünge (15) ausgebildet sind.

5. Vorrichtung nach Anspruch 4,
**dadurch gekennzeichnet,**
**dass** die Vorsprünge (15) durch Fräsen einstückig mit der Halteplatte (4) ausgebildet und mittels Fräsen aus einem Plattenrohling hergestellt sind.

6. Vorrichtung nach einem der Ansprüche 3 bis 5,
**dadurch gekennzeichnet,**
**dass** die Form einer ersten Ausnehmung (12a) in der Draufsicht auf die Halteplatte (4) der Form einer zu testenden Leiterplatte (16) entspricht, und die Form einer zweiten Ausnehmung (12b) in der Draufsicht spiegelsymmetrisch zur ersten Ausnehmung (12a) ist.

7. Vorrichtung nach Anspruch 6,
**gekennzeichnet durch**
mehrere Paare spiegelsymmetrisch ausgebildeter Ausnehmungen (12a, 12b).

8. Vorrichtung nach Anspruch 7,
**dadurch gekennzeichnet,**
**dass** Traversen (5) das Prüffeld (2) überspannen und ortsfest angeordnet sind, und dass die Kontaktfinger (10) mittels Schwenkarme (25) an den Traversen (5) angeordnet sind, so dass die Kontaktfinger (10) eine streifenförmigen Prüfzone (26) des Prüffeldes (2) abdecken, wobei sich die Prüfzonen (26) benachbarter Traversen (5) überlappen, und
**dass** ein Paar spiegelsymmetrisch ausgebildeter Ausnehmungen (12a, 12b) im überlappenden Bereich benachbarter Prüfzonen (26) angeordnet ist

9. Vorrichtung nach einem der Ansprüche 1 bis 8,
**dadurch gekennzeichnet,**
**dass** eine Messstation (22) zum Messen von Verzügen und/oder Versätzen von Leiterplattentestpunkten (20) vorgesehen ist, wobei die Messstation (22) außerhalb des Prüffeldes (2) angeordnet ist, und derart ausgebildet ist, dass die einzelnen Leiterplatten (16) in die Halteeinrichtung (4) eingesetzt und bzgl. eines durch die Halteeinrichtung festgelegten Koordinatensystems vermeßbar sind.

10. Vorrichtung nach Anspruch 9,
**dadurch gekennzeichnet,**
**dass** die Halteeinrichtung (4) zumindest zwei elektrische Kontakte (21) zum Kontaktieren mittels der Kontaktfinger (10) aufweist, um die Position der Halteeinrichtung (4) im Prüffeld (2) der Vorrichtung (1) zu bestimmen.

11. Verfahren zum Prüfen von Leiterplatten
wobei Kontaktfinger (10) einer Prüfvorrichtung in einer Ebene parallel zu einem Prüffeld verfahren werden, und zwei Kontaktfinger (10) ein Sondenpaar bilden, das Bestandteil eines Prüfstromkreises ist,
die Kontaktfinger (10) auf Leiterplattentestpunkten (20) einer zu testenden Leiterplatte (16) positioniert werden, um während eines Prüfvorganges mehrere gleichzeitig in die Prüfvorrichtung (1) einbringbare Leiterplatten (16) zu prüfen,
zwei Sätze (18, 19) von Kontaktfingern (10) vorgesehen sind, wobei ein Satz (18) zum Prüfen der Vorderseite und der andere Satz zum Prüfen der Rückseite einer der zu testenden Leiterplatte (10) angeordnet sind, und
die zu testenden Leiterplatten mit einer Halteeinrichtung (4) zwischen den beiden Sätzen (18,19) von Kontaktfingern (10) angeordnet werden,
**dadurch gekennzeichnet,**
**dass** die Halteeinrichtung (4) Aufnahmebereiche zum Aufnehmen von zumindest zwei zu testenden Leiterplatten (16) aufweist, und zumindest eine der zu testenden Leiterplatten (16) mit ihrer Vorderseite und die andere zu testende Leiterplatte (16) mit ihrer Rückseite zu einem der beiden Sätze (18,19) von Kontaktfingern (10) weisend angeordnet wird, und
**dass** mit den beiden Sätzen (18,19) von Kontaktfingern (10) die Leiterplattentestpunkte (20) sowohl der Vorder- als auch der Rückseiten der zu testenden Leiterplatten (16) während eines Prüfvorganges kontaktiert werden.

## Claims

1. A circuit board tester including
a contact array (2),
contact fingers (10) arranged for travelling in a plane parallel to said contact array, two contact fingers (10) forming a probe pair as a component of a test current circuit, a control means (11) for positioning said contact fingers (10) on circuit board test points (20) of a circuit board (16) to be tested, said circuit boards (16) being insertable into said tester (1) simultaneously during a test procedure being tested,
two sets (18, 19) of contact fingers (10), one set (18) being arranged for testing the face side and the other set for testing the rear side of a circuit board (10) to be tested, and
arranged between said two sets (18, 19) of contact fingers (10) is a holder means (4) for holding a circuit board (16) to be tested,
**characterised in that**
the holder (4) has portions for accommodating at least two circuit boards (16) to be tested, at least one of said circuit boards (16) to be tested being insertable in said holder means (4) with its face side, and the other circuit board (16) to be tested with its rear side, facing one of said two sets (18, 19) of contact fingers (10), and said control means (11) is configured such that with both sets (18, 19) of contact fingers (10) the circuit board test points (20) on both the face and rear sides of said circuit board (16) to be tested can be contacted during a test procedure.

2. The tester as set forth in claim 1
**characterized in that**
roughly half of said circuit boards (16) to be tested is insertable in said holder plate (4) with their face side facing one of said sets (18) of contact fingers (10) and the other half of said circuit boards (16) to be tested being inserted with their rear side facing said set (18) of contact fingers (10).

3. The tester as set forth in claim 1 or 2,
**characterized in that**
said holder means comprises a holder plate (4) in which windows (12) are provided having roughly the shape of said circuit boards (16) to be tested and provided with holding elements (15) for holding said circuit boards (16) to be tested.

4. The tester as set forth in claim 3,
**characterized in that**
said holding elements are configured as ledges (15) protruding from the locating edge (13) of said windows (12).

5. The tester as set forth in claim 4,
**characterized in that**
said ledges (15) are milled integrally with said holder plate (4) and produced by milling from a plate blank.

6. The tester as set forth in any of the claims 3 to 5,
**characterized in that**
the shape of a first window (12a) in viewing said holder plate (4) from above corresponds to the shape of a circuit board (16) to be tested and the shape of a second window (12b) viewed from above is mirror-symmetrical to said first window (12a).

7. The tester as set forth in claim 6,
**characterized in that**
several pairs of mirror-symmetrical windows (12a, 12b) are provided.

8. The tester as set forth in claim 7,
**characterized in that**
cross members (5) cover the extent of said test array (2) and are arranged stationary and said contact fingers (10) are arranged by means of swivel arms (25) on said cross members (5) so that said contact fingers (10) cover a strip-shaped test zone (26) of said test array (2), said test zones (26) of adjacent cross members (5) overlapping and
a pair of mirror-symmetrical configured windows (12a, 12b) is arranged in said overlapping portion of adjacent test zones (26).

9. The tester as set forth in any of the claims 1 to 8,
**characterized in that**
a mapping station (22) for mapping offsets and/or displacements of said circuit board test points (20) is provided, said mapping station (22) being arranged outside of said test array (2) and configured such that said individual circuit boards (16) are inserted in said holder plate (4) permitting mapping relative to a system of coordinates defined by said holder means.

10. The tester as set forth in claim 9,
**characterized in that**
said holder means (4) comprises at least two electric contacts (21) for contacting by means of said contact fingers (10) to detect the position of said holder means (4) in said test array (2) of said tester (1).

11. Method for the testing of circuit boards
wherein contact fingers (10) of a tester are moved in a plane parallel to a test array, and two contact fingers (10) form a probe pair which is part of a test circuit,
the contact fingers (10) are positioned on circuit board test points (20) of a circuit board (16) to be tested, in order to test during a test process several circuit boards (16) which may be inserted in the tester simultaneously,
two sets (18, 19) of contact fingers (10) are provided, wherein one set (18) is arrange to test the face side and the other set to test the rear side of a circuit board (16) to be tested, and
the circuit boards to be tested are located between the two sets (18, 19) of contact fingers (10) by a holder means (4),
**characterised in that**
the holder (4) has portions for accommodating at least two circuit boards (16) to be tested, at least one of said circuit boards (16) to be tested being insertable in said holder means (4) with its face side, and the other circuit board (16) to be tested with its rear side, facing one of said two sets (18, 19) of contact fingers (10), and
that with both sets (18, 19) of contact fingers (10) the circuit board test points (20) on both the face and rear sides of said circuit board (16) to be tested can be contacted during a test procedure.

## Revendications

1. Dispositif pour tester des cartes de circuits imprimés avec
- une zone de test (2),
- des doigts de contact (10), sont disposés de manière déplaçable dans un plan parallèle à la zone de test, deux doigts de contact (10), formant une paire de sondes qui fait partie intégrante d'un circuit de test,
- un dispositif de commande (11) pour le positionnement des doigts de contact (10) sur des points test d'une carte de circuits imprimés (16) à tester, les cartes de circuits imprimés (16) pouvant être introduites simultanément dans le dispositif de test (1) étant testées pendant une opération de test,
- deux ensembles (18, 19) de doigts de contact (10), un ensemble (18) étant disposé pour tester la face avant et l'autre ensemble pour tester la face arrière d'une des cartes de circuits imprimés (10) à tester, et
un dispositif de retenue (4) entre les deux ensembles (18, 19) de doigts de contact (10) pour la retenue d'une carte de circuits imprimés (16) à tester
**caractérisé en ce que**
le dispositif de retenue (4) présente des zones de logement pour le logement d'au moins deux cartes de circuits imprimés (16) à tester, les cartes de circuits imprimés à tester pouvant être insérées dans le système de retenue (4), la face avant d'au moins l'une des cartes (16) à tester et la face arrière de l'autre carte à tester (16) étant dirigées vers l'un des deux ensembles (18, 19) de doigts de contact, (10), et
**en ce que** le dispositif de commande (11) est conçu de telle sorte que, avec les deux ensembles (18, 19) de doigts de contact (10), on peut établir le contact avec les points test (20) des cartes de circuits imprimés aussi bien des faces avant que des faces arrière des cartes (16) à tester pendant une opération de test.

2. Dispositif selon la revendication 1,
**caractérisé en ce que**
environ la moitié des cartes de circuits imprimés (16) à tester peut être insérée dans le dispositif de retenue (4) avec leur face avant dirigée vers l'un des ensembles (18) de doigts de contact (10) et l'autre moitié des cartes de circuits imprimés (16) à tester avec leur face arrière dirigée vers cet ensemble (18) de doigts de contact (10).

3. Dispositif selon la revendication 1 ou 2,
**caractérisé en ce que**
l'appareil de retenue est constituée par une plaque de retenue (4), dans laquelle sont formés des évidements (12), qui présentent à peu près la forme des cartes de circuits imprimés (16) à tester et qui sont pourvus d'éléments de retenue (15) pour la retenue des cartes de circuits imprimés (16) à tester.

4. Dispositif selon la revendication 3,
**caractérisé en ce que**
les éléments de retenue sont conçus comme des saillies (15) débordant du bord de délimitation (13) des évidements (12).

5. Dispositif selon la revendication 4,
**caractérisé en ce que**
les saillies (15) sont conçues par fraisage d'une seule pièce avec la plaque de retenue (4) et sont fabriquées par fraisage à partir d'une ébauche de plaque.

6. Dispositif selon l'une quelconque des revendications 3 à 5,
**caractérisé en ce que**
la forme d'un premier évidement (12a) correspond, en vue de dessus de la plaque de retenue (4), à la forme d'une carte de circuits imprimés (16) à tester et la forme d'un second évidement (12b), en vue de dessus, est symétrique par rapport au premier évidement (12a).

7. Dispositif selon la revendication 6,
**caractérisé par**
plusieurs paires d'évidements (12a, 12b) conçus de façon symétrique.

8. Dispositif selon la revendication 7,
**caractérisé en ce que** des traverses (5) entourent la zone de test (2) et sont disposées de façon fixe, et **en ce que** les doigts de contact (10) sont disposés au moyen de bras pivotants sur les traverses (5), de sorte que les doigts de contact (10) recouvrent une zone de test (26) en forme de bande de la zone de test (2), les zones de test (26) de traverses (5) voisines se chevauchant, et
**en ce qu'**une paire d'évidements (12a, 12b) réalisés de façon symétrique est disposée dans la zone de chevauchement de zones de test (26) voisines.

9. Dispositif selon l'une quelconque des revendications 1 à 8,
**caractérisé en ce que**
un poste de mesure (22) est prévu pour la mesure de déformations et/ou de déports de points test de cartes de circuits imprimés (20), le poste de mesure (22) étant disposé à l'extérieur de la zone de test (2) et conçu de telle sorte que les cartes de circuits imprimés (16) individuelles sont insérées dans le dispositif de retenue (4) et peuvent être mesurées par rapport à un système de cordonnées défini par le dispositif de retenue.

10. Dispositif selon la revendication 9,
**caractérisé en ce que**
l'appareil de retenue (4) présente au moins deux contacts (21) électriques pour l'établissement d'un contact au moyen des doigts de contact (10), afin de déterminer la position du dispositif de retenue (4) dans la zone de test (2) du dispositif (1).

11. Procédé pour tester des cartes de circuits imprimés, dans lequel
des doigts de contact (10) d'un dispositif de test sont déplacés dans un plan parallèle à une zone de test, et deux doigts de contact (10) forment une paire de sondes qui font partie intégrante d'un circuit de test,
les doigts de contact (10) sont positionnés sur les points test (20) d'une carte de circuits imprimés (16) à tester, afin de tester pendant une opération de test plusieurs cartes de circuits imprimés (16) pouvant être introduites simultanément dans le dispositif de test (20),
deux ensembles (18, 19) de doigts de contact (10) sont prévus, un ensemble (18) et l'autre ensemble étant disposés respectivement pour le test de la face avant et pour le test de la face arrière d'une carte de circuits imprimés à tester (10), et
les cartes de circuits imprimés à tester sont disposées avec un dispositif de retenue (4) entre les deux ensembles (18, 19) de doigts de contact (10), procédé **caractérisé en ce que**
le dispositif de retenue (4) présente des zones de logement pour le logement d'au moins deux cartes de circuits imprimés (16) à tester, et au moins l'une des cartes de circuits imprimés (16) à tester étant disposée avec sa face avant et l'autre carte (16) à tester avec sa face arrière dirigées vers l'un des deux ensembles (18, 19) de doigts de contact (8) et
**en ce que**, avec les deux ensembles (18, 19) de doigts de contact (10), les points test de cartes de circuits imprimés (20) aussi bien des faces avant que des faces arrière des cartes de circuits imprimés (16) à tester sont mis en contact pendant une opération de test.
